# EUROPEAN PATENT APPLICATION

(11) **EP 1 757 714 A2**
(43) Date of publication of application: **28.02.2007**
(21) Application number: 06017587.4
(22) Date of filing: 23.08.2006
(51) Int. Cl.: C23C 24/04, H01L 41/08, B01J 2/14

(54) **Method of producing film and method of producing ink-jet head**

(30) Priority: 24.08.2005 JP 2005242986
(71) Applicant: Brother Kogyo Kabushiki Kaisha, Nagoya-shi, Aichi-ken 467-8561 (JP); National Institute of Advanced Industrial Science and Technology, Tokyo 100-8921 (JP)
(72) Inventor: Yasui, Motohiro Brother Kogyo K.K., Mizuho-ku Nagoya-shi Aichi-ken 467-8562 (JP); Akedo, Jun c/oNational Inst. Advanced Ind. Science, Ibaraki 305-8564 (JP)
(74) Representative: Kuhnen & Wacker

(57) **Abstract**

A method of producing a film includes: a heating treatment step of performing a heating treatment for ceramic particles; a film-forming step for forming the film by jetting, onto a substrate, an aerosol containing the ceramic particles which have been subjected to the heating treatment so as to make the ceramic particles adhere to the substrate; and an annealing-treatment step for performing an annealing treatment for the film. Accordingly, it is possible to previously vaporize and remove water and an additive which would otherwise cause gasification in the annealing treatment step, thereby preventing the defect and destruction of the film in the annealing treatment step. Thus, it is possible to provide a piezoelectric actuator plate, for ink-jet head, having satisfactory piezoelectric characteristics.

## Description

### CROSS REFERENCE TO RELATED APPLICATION

The present application claims priority from Japanese Patent Application No.2005-242986, filed on August 24, 2005, the disclosure of which is incorporated herein by reference in its entirety.

### BACKGROUND OF THE INVENTION

### Field of the Invention;

The present invention relates to a method of producing a film and a method of producing an ink-jet head.

### Description of the Related Art:

As a method of producing a piezoelectric actuator used, for example, in an ink-jet head or the like, there is a method called as the aerosol deposition method (AD method). Japanese Patent Application Laid-open No. 2001-152360 discloses a method of forming a piezoelectric film by jetting a substance (aerosol), in which fine particles, of a piezoelectric material such as Lead Zirconate Titanate (PZT) or the like, is dispersed in a gas is jetted toward a surface of a substrate such that the fine particles are collided and deposited onto the substrate.

In this case, an annealing treatment needs to be performed for the piezoelectric film formed by the AD method as described above so as to impart, to the piezoelectric film, piezoelectric characteristics which is required to bend or warp the substrate sufficiently. According to the experiments performed by the inventors of the present invention, however, when an annealing treatment was performed at a high temperature to obtain sufficient piezoelectric characteristics for the piezoelectric film, fault or defect was generated in the film in some cases, and the film was even destroyed in an extreme case. Such a situation, if occurred, leads to the degradation of insulating property, and consequently to the degradation of piezoelectric characteristics, improvement of which is thus required.

### SUMMARY OF THE INVENTION

An object of the present invention is to provide a method of producing a film with which it is possible to prevent the defect from being generated in a film and/or the film being destroyed at the time of annealing treatment, and to provide a method of producing an ink-jet head which uses such a film.

The inventors found out the following fact, through their diligent research for developing the method of producing a film capable of preventing the film from being destroyed at the time of annealing treatment.

It is considered that a component, which is gasified in the annealing treatment step or process to cause any fault to be generated in a film, is water, additive(s), any decomposed matter of the additives or the like entered into and mixed in the ceramic particles in the preparing step for the ceramic particles.

Namely, the steps for preparing ceramic particles to be used in the AD method are normally that a material is first ground or pulverized, then classified so as to obtain fine powder of an appropriate particle size. Alternatively, when a ceramics material is composed or synthesized of a plurality of materials, the procedures taken are that the material powders are first mixed or blended, and then subjected to a pre-sintering, followed by being pulverized. In this case, when the powders are blended by means of wet blending, water is entered and mixed in a solvent used in some cases. Further, a sintering-aiding agent is added in the material powder to facilitate the sintering in some cases. Furthermore, in some cases, a dispersant and/or a coating agent are added after the pulverization so as to prevent aggregation of the particles. Moreover, when the material powder itself easily generates a hydrate, it is considered that the material ore, which is to be pulverized to produce the material powder later, already contains water and/or a volatile component. Among the water, the additive, and the like, a component which is decomposed and vaporized at a temperature not more than the annealing temperature causes the defect in the film. Regarding the water, it is considered that the water is physisorbed water which entered to and mixed in the material powder by physisorption in which the water is adsorbed to a pore on a surface of powder, and chemisorbed water which entered to and mixed in the material powder by chemisorption in which the water is contained as crystal water during the preparation.

Accordingly, it is possible to prevent the occurrence of defect in the film and the destruction of film in the annealing step by previously subjecting the ceramic particles to a heating treatment prior to film formation so as to vaporize and thus remove water and an additive contained in the ceramic particles. The present invention has been made based on such novel knowledge as described above.

According to a first aspect of the present invention, there is provided a method of producing a film, including:
a heating treatment step for performing a heating treatment for the ceramic particles;
a film-forming step for forming the film by jetting, onto a substrate, an aerosol containing the ceramic particles which have been subjected to the heating treatment so as to adhere the ceramic particles to the substrate; and
an annealing-treatment step for performing an annealing treatment for the film.

According to a second aspect of the present invention, there is provided a method of producing an ink-jet head which includes: an ink channel forming body provided with a plurality of pressure chambers each of which communicates with an ink discharge nozzle for discharging an ink and each of which has an opening, the opening being open on a side of a surface of the ink channel forming body; and a piezoelectric actuator provided with a vibration plate arranged on the side of the surface of the ink channel forming body so as to close the opening of each of the pressure chambers, and a piezoelectric film stacked on the vibration plate, the method including:
a heating treatment step for performing a heating treatment for particles of a piezoelectric material;
a piezoelectric film-forming step for forming the piezoelectric film by jetting, onto the vibration plate, an aerosol containing the particles of the piezoelectric material which have been subjected to the heating treatment so as to adhere the particles of the piezoelectric material to the vibration plate;
an annealing-treatment step for performing an annealing treatment for the piezoelectric film; and
an electrode layer-forming step for forming an electrode layer on the piezoelectric film.

A heating temperature in the heating treatment step may be appropriately set considering, for example, a kind of a component to be removed. For example, the water adsorbed in a pore in the surface of ceramic particle (physisorbed water) can be removed at a temperature of about not less than 150°C. Further, a gassified component, contained in an additive such as a dispersant and/or a sintering-aiding agent normally used to prepare the ceramic particles, can be removed at a temperature of about not less than 200 to 400°C. In particular, when the material forming the ceramic particles contains chemically adsorbed water (chemisorbed water), it is preferable that the heating is performed at not less than a temperature (about 600°C) at which the water is released or discharged.

Furthermore, when the heating temperature is a temperature equal to or not less than the annealing temperature in the annealing step, all the components which are gasified at the annealing temperature are previously removed, which is particularly preferred. Moreover, it is enough that the heating time has duration capable of removing a component contained in the ceramic particles and easily gasified. Specifically, it is preferable that the heating time is not less than 30 minutes. Furthermore, it is preferable to perform a dry pulverization step so as to prevent the particles from aggregating due to static electricity and/or intermolecular force acting on the powder surface when being heated.

In the method of producing the film and the method of producing the ink-jet head of the present invention, the heating temperature in the heating treatment step may be 450°C to 850°C. In this case, volume resistivity becomes great and satisfactory insulation property is secured.

As a kind of the ceramic particles of the present invention, the kind is not specifically limited as long as ceramic particles are normally used for forming the film, and can be exemplified by α-alumina, zirconia, partially stabilized zirconia, and the like. Further, the producing method of the present invention can be used suitably for forming a piezoelectric film in the piezoelectric actuator used, for example, in an ink-jet head or the like. In this case, as the ceramic particles, particles of a material having a perovskite structure and normally used as a piezoelectric material, such as Lead Zirconate Titanate (PZT), Lead Magnesium Niobate (PMN) and the like.

When the ceramic particles are particles made of a single material such as α-alumina or the like, the ceramic particles can be obtained by pulverizing its material and then performing heating treatment therefor. Alternatively, when the ceramic particles are particles made of ceramics composed of a plurality of materials such as PZT or the like, target ceramic particles can be obtained by first blending material powders, then performing calcination and pulverization therefor to obtain fine powder, and then subjecting the obtained fine powder to heating treatment.

It is preferable that in the ceramic particles of the present invention, weight loss rate by thermogravimetry is not more than 0.2 weight % when the ceramic particles are heated from an ordinary temperature to 900°C; and more preferable that the weight loss rate by thermogravimetry is not more than 0.18 weight % when the ceramic particles are heated from an ordinary temperature to 600°C. Here, it is possible to consider that weight loss amount by the heating is water (physisorbed water, chemisorbed water) and/or a gasified component of an additive or the like contained in the ceramic particles. In this manner, when the film is formed by using ceramic particles in which the weight loss amount by the heating is extremely small, namely the gasified component is extremely small, it is possible to make the generation of gas at the time of annealing treatment to be in ultratrace amount, thereby preventing the destruction of the film.

Further, it is particularly preferable that weight loss rate by thermogravimetry is not more than 0.15 weight % when the ceramic particles are heated from an ordinary temperature to 180°C. The weight loss amount at the temperature of 180°C is physisorbed water adsorbed to the surface of particles and a volatile component contained in an additive such as a dispersant. By removing the physisorbed water and volatile component in advance, it is possible to prevent a newly formed surface, which is formed by the collision of the particles onto the substrate and the destruction of the particles at the time of film forming and which is highly active, from being polluted by these components, thereby improving the quality of the film formation performance and the quality of the formed film.

Further, it is preferable that, in the ceramic particles of the present invention, specific surface area is not more than 10 m²/g. In the particles having such a small specific surface area, an amount of water adsorbable to the surface of the particles is small, thereby making it possible to suppress the amount of gas generated at the time of annealing treatment to be small.

As an amount of crystal water contained in the ceramic particles is smaller, hardness and crushing strength (compressive strength) of the ceramic particles become greater. Accordingly, the hardness and crushing strength can be used as a content index of the crystal water. From this point of view, it is preferable that the ceramic particles of the present invention has a hardness measured by using a nano-indenter is in a range of 50Hv to 800Hv as converted to Vickers hardness, and a crushing strength is in a range of 0.5 GPa to 8 GPa. In such ceramic particles, an amount of crystal water contained therein is extremely small. Accordingly, even when an annealing treatment is performed at a high temperature, it is possible to make the generation of gas at the time of the annealing treatment to be in ultratrace amount, thereby preventing the destruction of the film.

Furthermore, crystallinity of the ceramic particles measured by the X-ray diffraction method can also be used as a content index of the crystal water. From this point of view, it is preferable that the ceramic particles of the present invention has a crystallinity measured by the X-ray diffraction method is not less than 80 %. In such ceramic particles, an amount of crystal water contained therein is extremely small. Accordingly, even when an annealing treatment is performed at a high temperature, it is possible to make the generation of gas at the time of the annealing treatment to be in ultratrace amount, thereby preventing the destruction of the film.

According to the present invention, after preparing the ceramic particles, the heating treatment is performed for the ceramic particles before performing the film formation. Therefore, it is possible to previously vaporize and thus remove water and an additive which would otherwise cause the gasification in the subsequent annealing step, and thus it is possible to prevent the defect and destruction of the film in the annealing step. Thus, it is possible to form a film of a high quality excellent in insulating property and the like. Further, by applying the production method of the present invention to a formation of piezoelectric film in a piezoelectric actuator, it is possible to prevent the degradation of the piezoelectric characteristics due to the defect and destruction of the film, thereby obtaining a piezoelectric actuator having satisfactory piezoelectric characteristics.

### BRIEF DESCRIPTION OF THE DRAWINGS

Fig. 1 is a cross-sectional view of an ink-jet head of an embodiment of the present invention;
Fig. 2A is a side cross-sectional view showing state in which a vibration plate is joined to a pressure-chamber plate in a production process of an actuator plate, Fig. 2B is a side cross-sectional view showing a state in which a piezoelectric film is formed, and Fig. 2C is a side cross-sectional view showing a state in which an upper electrode is formed;
Fig. 3 is a schematic diagram of a film forming apparatus;
Fig. 4A is a side cross-sectional view showing a state of a piezoelectric film in an annealing step using material particles not subjected to a heating treatment, Fig. 4B is a side cross-sectional view showing a state of a piezoelectric film in the annealing step using material particles which have been subjected to the heating treatment;
Fig. 5 is a flow chart schematically showing a process of producing the piezoelectric film;
Fig. 6A is a photograph showing a cross section of a substrate when the substrate has been subjected to the heating treatment at 500°C, and Fig. 6B is a photograph showing a cross section of a substrate when the substrate has been subjected to the heating treatment at 700°C;
Fig. 7 shows results of measurement by the X-ray diffraction for a case in which piezoelectric material particles have been heated and a case in which the piezoelectric material particles have not been heated;
Fig. 8 is a graph showing results of measurement of thermogravimetry and differential thermal of the piezoelectric material particles;
Fig. 9 is a flow chart schematically showing a producing process of an ink-jet head;
Fig. 10 is a diagram showing a particle size distribution of alumina powder before and after the heating treatment;
Fig. 11 is a diagram showing a particle size distribution of PZT powder before and after the heating treatment; and
Fig. 12 is a diagram showing a relationship between the heating treatment for the PZT powder and the electrical characteristics of the PZT powder.

### DESCRIPTION OF THE PREFERRED EMBODIMENTS

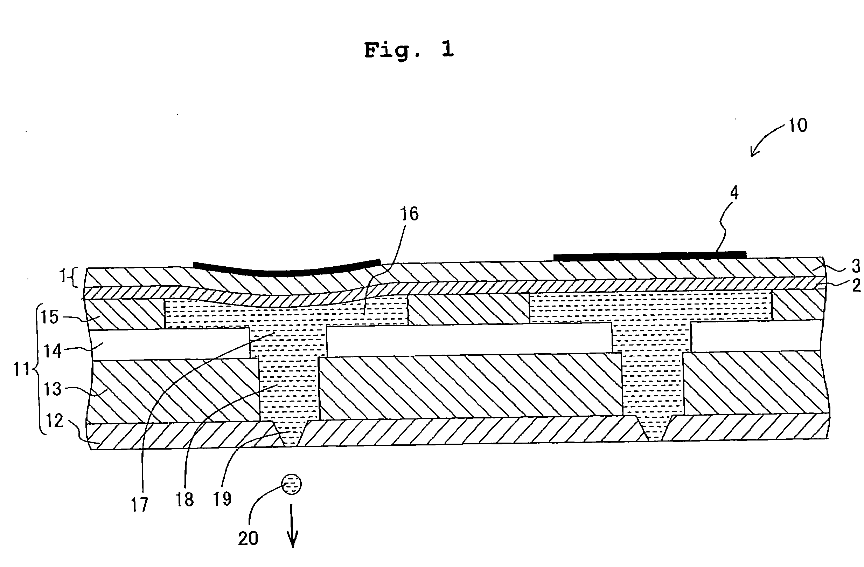

An embodiment of the present invention will be described in detail with reference to Figs. 1 to 5. In this embodiment, the present invention is applied for producing a piezoelectric actuator for an ink-jet head.

Fig. 1 shows an ink-jet head 10 of this embodiment. The ink-jet head 10 includes a channel unit 11 (ink channel forming body) which has a plurality of pressure chambers 16 accommodating an ink 20 and an actuator plate 1 (piezoelectric actuator) which is joined to the channel unit 11 so as to close the pressure chambers 16.

The channel unit 11 as a whole is in the form of a flat plate in which a nozzle plate 12, a manifold plate 13, a channel plate 14, and a pressure-chamber plate 15 are stacked in layers in sequence, and the channel unit 11 has a construction in which the plates 12, 13, 14, and 15 are joined to one another with an epoxy-based thermosetting adhesive.

The nozzle plate 12 is formed of a polyimide-based synthetic resin material, and a plurality of ink-discharge nozzles 19 for jetting ink 20 are formed and aligned in the nozzle plate 12. The manifold plate 13 is formed of a metal material such as stainless steel, and a plurality of nozzle channels 18 connected to the nozzles 19 respectively are provided in the manifold plate 13. The channel plate 14 is formed also of a metallic material such as stainless steel, and a plurality of pressure channels 17 communicating with the nozzle channels 18 respectively are provided in the channel plate 14. The pressure-chamber plate 15 is also formed a metallic material such as stainless steel, and a plurality of pressure chambers 16 communicating with the pressure channels 17 respectively are provided in the pressure-chamber plate 15. The pressure chambers 16 are connected to an ink tank (not shown), via a manifold channel and a common ink chamber (not shown) provided in the manifold plate 13 and the channel plate 14 respectively. Thus, there are formed channels each of which is from the common ink chamber connected to the ink tank to one of the ink-discharge nozzles 19, via the manifold channel, one of the pressure chambers 16, one of the pressure channels 17, and one of the nozzle channels 18.

The actuator plate 1, which is stacked on the channel unit 11, is constructed of a vibration plate 2 which serves also as a lower electrode constructing a part of wall surface of each of the pressure chambers 16; a piezoelectric film 3 formed on the vibration plate 2; and upper electrodes 4 provided on the piezoelectric film 3.

The vibration plate 2 is formed of a metallic material such as stainless steel (SUS 430, SUS304) in a rectangular shape, and the vibration plate 2 is joined to the upper surface of the channel unit 11 by thermal diffusion of the vibration plate 2 and the channel unit 11 or with an epoxy-based thermosetting adhesive coated on the upper surface of the channel unit 11, and the vibration plate 2 is arranged so as to cover the entire upper surface of the channel unit 11.

The piezoelectric film 3 is arranged on one surface of the vibration plate 2 on a side opposite to the other surface of the vibration plate 2 facing the channel unit 11. The piezoelectric film 3 is formed of a ferroelectric piezoelectric ceramics material such as lead zirconate titanate (PZT), and is stacked on the surface of the vibration plate 2 with a uniform thickness. This piezoelectric film 3 is formed by the aerosol deposition method, and subjected to a polarization treatment such that the piezoelectric film 3 is polarized in a direction of thickness of the piezoelectric film 3.

A plurality of upper electrodes 4 is provided on a surface, of the piezoelectric film 3, on a reverse side of the other surface of the piezoelectric film 3 in which the piezoelectric film 3 is tightly adhered to the vibration plate 2. Each of the upper electrodes 4 is provided on the surface of the piezoelectric film 3 at an area corresponding to an opening of one of the pressure chambers 16. The upper electrodes 4 are connected to a drive circuit IC.

Upon performing a printing, a predetermined drive signal is outputted from the drive circuit IC to a certain upper electrode 4 of the upper electrodes 4, then electric potential of the upper electrode 4 becomes higher than an electric potential of the vibration plate 2 used as the lower electrode, and an electric field is applied in a polarization direction (direction of thickness) of the piezoelectric film 3. Then, an area of the piezoelectric film 3 sandwiched between the upper electrode 4 and the vibration plate 2 is expanded (extended) in the thickness direction and is contracted in a plane direction of the piezoelectric film 3. Accordingly, the area of the piezoelectric film 3 and an area of the vibration plate 2 (namely, the actuator plate 1) which correspond to an opening of a pressure chamber 16 associated with the upper electrode 4 are locally deformed (unimorph deformation) to project toward the pressure chamber 16. Therefore, the volume of the pressure chamber 16 is lowered, a pressure of the ink 20 in the pressure chamber 16 is raised, and the ink 20 is jetted from the ink-discharge nozzle 19 corresponding to the pressure chamber 16. Thereafter, when the upper electrode 4 returns to an electric potential same as the electric potential of the lower electrode (vibration plate 2), the piezoelectric film 3 and the vibration plate 2 restore to their original shape and the volume of the pressure chamber 16 returns to the original volume, thereby sucking the ink 20 from the manifold channel communicating with the ink tank. It should be noted that the material for forming the vibration plate 2 is not limited to a metallic material, and the vibration plate 2 may be constructed of a polyimide-base resin material or the like. In this case, the following construction is adopted in which a lower electrode is formed on the vibration plate 2 by a screen printing or the like; the piezoelectric film 3 is formed on the lower electrode so that the piezoelectric film 3 is stacked on the vibration plate 2 via the lower electrode, namely with the lower electrode being sandwiched between the piezoelectric film 3 and the vibration plate 2.

Next, an explanation will be given about a method of producing the actuator plate 1, for the ink-jet head 10, constructed as described above.

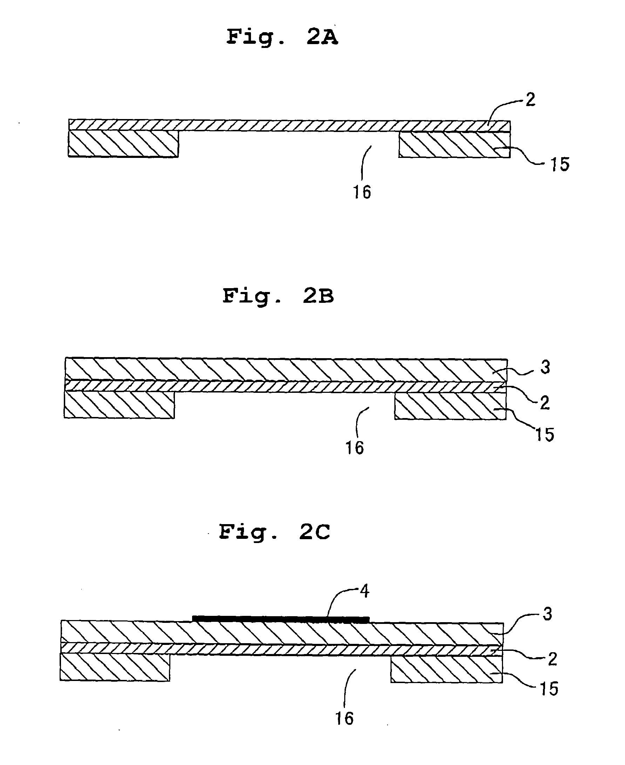

First, as shown in Fig. 2A, the vibration plate 2 formed of stainless steel is overlapped with the channel unit 11, while being positioned on the upper surface of the pressure chamber plate 15 in the channel unit 11, and joined to the pressure chamber plate 15, thereby closing the pressure chambers 16 by the vibration plate 2.

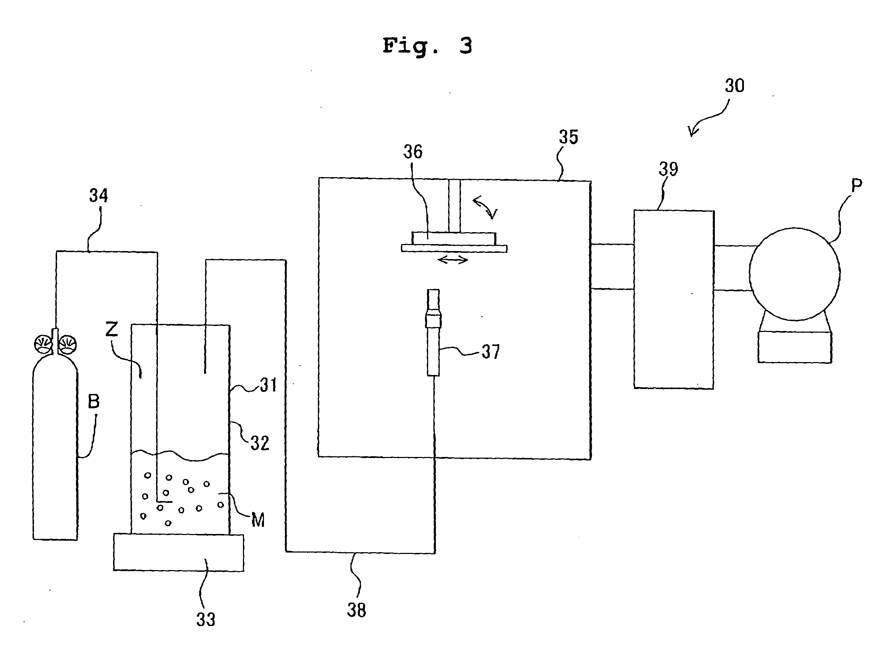

Next, as shown in Fig. 2B, the piezoelectric film 3 is formed by the aerosol deposition method (AD method). Fig. 3 shows a schematic diagram of a film forming apparatus 30 for forming the piezoelectric film 3. This film forming apparatus 30 includes an aerosol generator 31 which forms an aerosol Z by dispersing material particles (particulate material) M (ceramic particles) in a carrier gas, and a film forming chamber 35 for adhering the particles in the aerosol Z on a substrate by jetting the aerosol Z from a jetting nozzle 37.

The aerosol generator 31 includes an aerosol chamber 32 capable of accommodating the material particles M inside thereof, and a vibration unit 33 which is attached to the aerosol chamber 32 and which causes the aerosol chamber 32 to vibrate. A gas cylinder B for introducing the carrier gas is connected to the aerosol chamber 32 via an introduction pipe 34. An end of the introduction pipe 34 is positioned near the bottom surface in the aerosol chamber 32 so that the end is buried or embedded in the material particles M. As the carrier gas, an inert gas such as helium, argon, and nitrogen, or a gas such as air and oxygen can be used.

The film forming chamber 35 includes a stage 36 for attaching or mounting the substrate where the piezoelectric film will be formed, and the jetting nozzle 37 which is provided below the stage 36. The jetting nozzle 37 is connected to the aerosol chamber 32 via an aerosol supply pipe 38 so as to supply the aerosol Z in the aerosol chamber 32 to the jetting nozzle 37 through the aerosol supply pipe 38. Moreover, a vacuum pump P is connected to this film forming chamber 35 via a powder recovery unit 39 so as to decompress the inside of the film forming chamber 35.

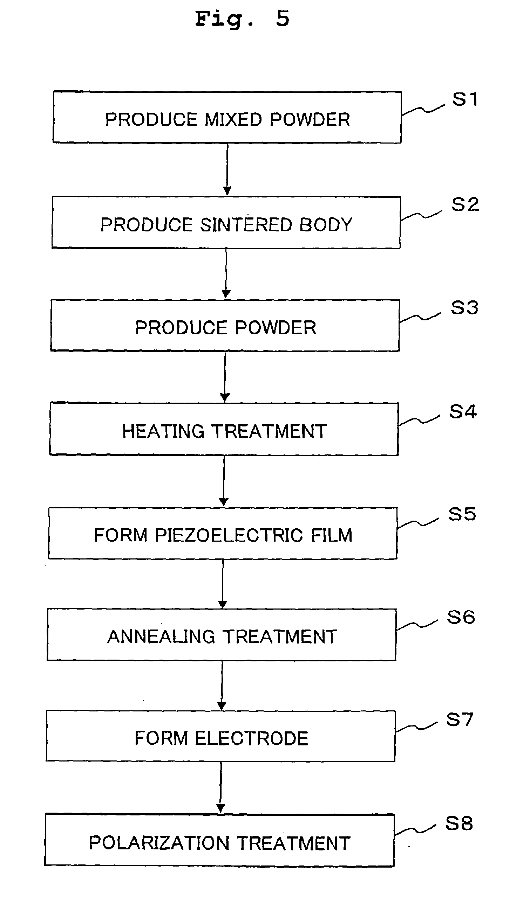

The steps for forming the piezoelectric film 3 by using this film forming apparatus 30 will be explained with reference to Fig. 5. First of all, material particles M to be used are synthesized or composed. As the material particles M, it is possible to use, for example, particles of lead zirconate titanate (PZT) which are particles of a piezoelectric material. The method of composing (synthesizing) the material particles M is as follows.

Lead oxide (PbO), titanium oxide (TiO₂), zirconium oxide (ZrO₂) are used as materials, and material powders of these substances are weighed based on a composition of target material particles M. The weighed material powders are pulverized with a ball mill and by using ethanol as a solvent while being mixed (mixed powder producing step: S1). The obtained mixed powder is subjected to pre-calcination in atmosphere, thereby obtaining pre-sintered body of lead zirconate titanate (PZT) (pre-sintered body producing step: S2). This pre-sintered body is pulverized while being added with a sintering-aiding agent such as LiBiO₂, and thus fine powder of PZT can be obtained (Powder producing step: S3). This fine powder is used as the material particles M.

Subsequently, the obtained material particles M are placed in an electric furnace set at a predetermined temperature, for example, 450°C to 850°C, and is subjected to heating for a predetermined period of time (Heating treatment step: S4). Accordingly, crystal water contained in the material particles M, adhered water adhered on the surface of material particles M, a component or components included in additives such as solvent, sintering-aiding agent and/or dispersant, used at the time of synthesizing (composing) the material particles are previously decomposed, vaporized and thus removed. It should be noted that after the heating treatment, the material particles M may be pulverized by using a dry-type ball mill apparatus (dry pulverization step). This is performed by placing the material particles M and a ball formed of highly pure zirconia or alumina in a pot formed of highly pure zirconia or alumina, and by rotating the pot. When the material particles M are heated, the material particles M are aggregated in some case due to the static electricity and/or intermolecular force acting on the surfaces of material particles M. However, the aggregated material particles M can be pulverized by being subjected to the dry pulverization step. The pulverization step may be performed as necessary. Here, when fine powder is adhered around material particles M in a large amount after the pulverization step, a piezoelectric film 3, to be formed in the piezoelectric film forming step which will be explained later on, is formed in a state that the fine powder is contained in the piezoelectric film 3. In such a case, when the fine powder is collided against the vibration plate 2, the fine powder hardly receives collision energy, thus is hardly deformable. Accordingly, void is formed around fine powder contained in the piezoelectric film 3, which in turn causes the degradation of the piezoelectric characteristics of the piezoelectric film 3 in some cases. Therefore, it is preferable that a heating treatment is further performed at around 850°C after the pulverization step so as to recover the piezoelectric characteristics.

After the preparation of the material particles M and the heating treatment for the material particles M have been completed, the film formation is performed (Piezoelectric film forming step: S5). First of all, the vibration plate 2 is set in the stage 36 of the film forming apparatus 30. Next, the material particles M, subjected to the heating treatment, are charged into the aerosol chamber 32.

Then, the carrier gas is introduced from the gas cylinder B so that the material particles M are made to rise up by gas pressure. At the same time, the aerosol chamber 32 is vibrated by the vibration unit 33, thereby mixing the material particles M with the carrier gas to generate the aerosol Z. Further, the inside of the film forming chamber 35 is decompressed by the vacuum pump P to generate pressure difference between the aerosol chamber 32 and the film forming chamber 35. Due to the pressure difference, the aerosol Z in the aerosol chamber 32 is jetted from the jetting nozzle 37 while accelerating the aerosol to a high velocity. The material particles M contained in the jetted aerosol Z are collided on the vibration plate 2 and deposited on the vibration plate 2, thereby forming the piezoelectric film 3.

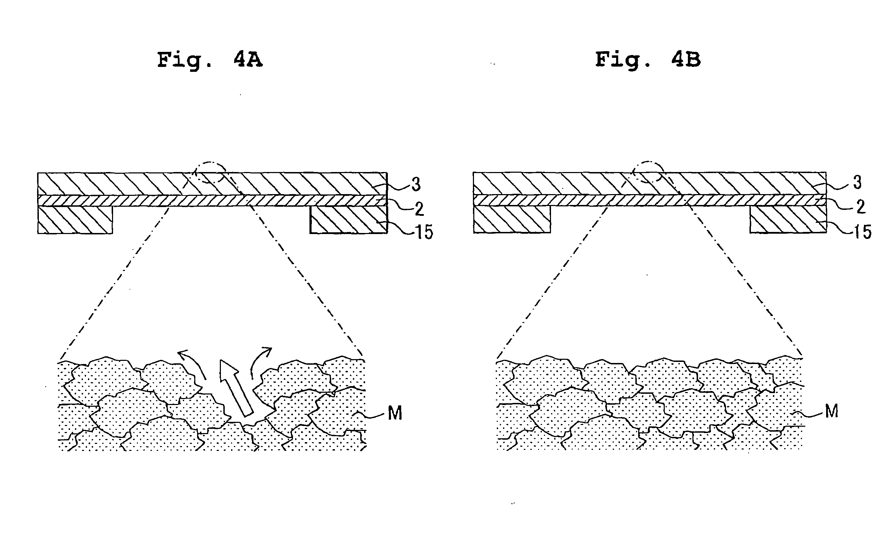

Next, the annealing treatment is performed for the formed piezoelectric film 3 (Annealing treatment step: S6). Here, in a case that the film formation is performed by using the material particles M which have not been subjected to the heating treatment, when the annealing treatment is performed at a high temperature (not less than 600°C, preferably not less than 850°C) for the purpose of obtaining sufficient piezoelectric characteristics, a part of a component contained in the piezoelectric film 3 is rapidly gasified and expanded, which in turn causes a defect in the film and thus destroys the film in some cases (Fig. 4A). In this embodiment, however, the component which is contained in the material particles M and would otherwise cause the gasification has been previously removed in the heating treatment step. Accordingly, it is possible to prevent the defect and destruction of the film, and consequently to obtain a piezoelectric film 3 having satisfactory piezoelectric characteristics (Fig. 4B).

Next, as shown in Fig. 2C, the upper electrodes 4 and a plurality of lead portions (not shown in the diagram) connected to the upper electrodes 4 respectively are formed on the upper surface of piezoelectric film 3 (electrode forming step: S7). For forming the upper electrodes 4 and the lead portions, for example, after forming a conductor film on the entire area of the piezoelectric film 3, a predetermined pattern may be formed by using a photolithographic etching method. Alternatively, the predetermined pattern may be formed by screen printing directly on the upper surface of the piezoelectric film 3.

Afterwards, an electric field stronger than at the time of a normal ink-jetting operation is applied between the upper electrodes 4 and the lower electrode (vibration plate 2), and the piezoelectric film 3 between both of the electrodes is polarized in the direction of thickness (Polarizing treatment step: S8). Thus, the actuator plate 1 is completed.

As explained above, according to this embodiment, after synthesizing the material particles M and before performing the film formation, the heating treatment for the material particles M is performed. Accordingly, the water and additive(s) which would otherwise cause the gasification in the annealing step performed later are previously vaporized and removed, thereby preventing the defect and destruction of the piezoelectric film 3 in the annealing step. Accordingly, it is possible to provide an actuator plate 1, for an ink-jet head 10, with satisfactory piezoelectric characteristics.

### Examples

Next, the present invention will be explained in further detail by examples.

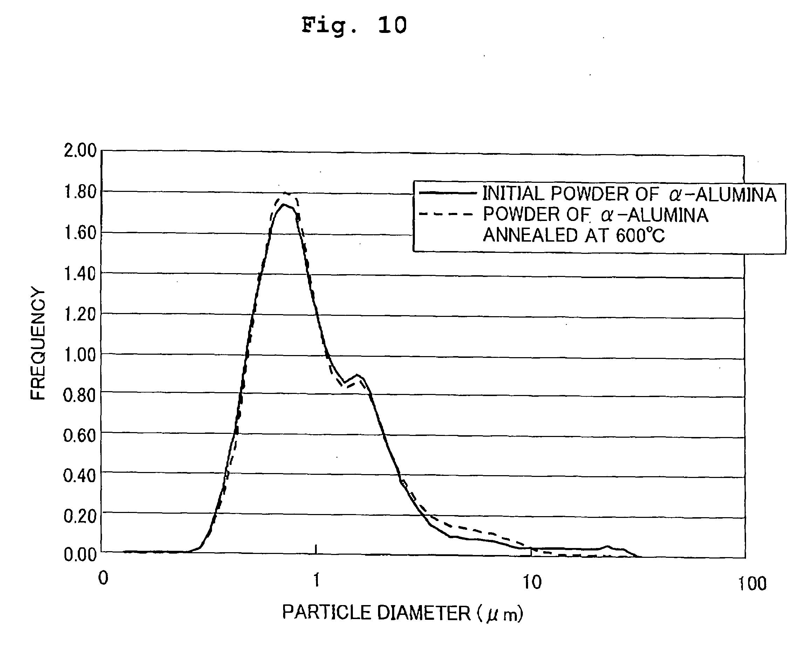

Examples and Comparative Examples for investigating the effect on the film by the presence or absence of heating treatment to the material particles
<Example 1-1>
1. Formation of Film
   (1) Preparation of ceramic particles
      As the material, α-alumina (obtained from Showa Denko Kabushiki Kaisha) was pulverized with a ball mill to obtain fine powder of α-alumina having a mean particle diameter of about 1 µm and a particle size distribution as shown in Fig. 10. The particle size distribution was measured by using a dry type particle-size distribution measuring apparatus (HELOS & RODOS, manufactured by Japan Laser Corporation). This fine powder was placed in a muffle furnace (FP100, manufactured by Yamato Scientific Co., Ltd.), and the temperature in the furnace was raised up to 600°C by taking one hour. After holding the temperature at 600°C for one hour, the inside of the furnace was cooled by natural cooling, and the fine powder was taken out. Fig. 10 also shows a particle size distribution of α-alumina after the heating treatment.
   (2) Film formation
      Stainless steel plate (SUS430) was used as the substrate, and the α-alumina powder prepared in above (1) was used as the material particles. Aerosol was jetted onto the substrate with the following condition that nozzle opening was 0.4 mm x 10 mm, pressure in the film forming chamber was 400 Pa, pressure in the aerosol chamber was 30,000 Pa, the kind of carrier gas was He, gas flow rate was 6.0 litter/min, the distance between nozzle and substrate was 10 to 20 mm. Thus, an insulating film was formed. The thickness of the film, after the measurement of step (unevenness) by using a surface roughness tester was approximately 3 µm.
   (3) Annealing treatment
Next, annealing treatment was performed for the formed insulating film. The temperature in the muffle furnace was raised up to 850°C, then the substrate having the film formed thereon was placed in the furnace, and maintained the temperature at 850°C for 10 minutes. Afterwards, the substrate was taken out of the furnace, and cooled by natural cooling down to the room temperature.

2. Measurement
An upper electrode having a size of 2 mm x 2 mm was formed on the insulating film by a sputtering using an Au target. The substrate was used as a lower electrode, a voltage of 50V was applied, and volume resistivity was measured.

<Example 1-2>
Particles of α-alumina were prepared and a film was formed in a similar manner as in Example 1-1 except that the thickness of the formed insulating film was 1 µm, and the measurement was performed.

<Comparative Example 1-1>
Particles of α-alumina were prepared and an insulating film was formed in a similar manner as in Example 1-1 except that no heating treatment was performed for the α-alumina powder, and the measurement was performed.

<Comparative Example 1-2>
Particles of α-alumina were prepared and an insulating film was formed in a similar manner as in Example 1-2 except that no heating treatment was performed for the α-alumina powder, and the measurement was performed.

<Measurement Results>
TABLE 1 shows results of measurement for Examples 1-1
and 1-2 and Comparative Examples 1-1 and 1-2.

**TABLE 1**

| | Comp. EX.1-1 | Comp. EX.1-2 | Ex. 1-1 | Ex. 1-2 |
|---|---|---|---|---|
| Heating Treatment | No | | Yes | |
| Thickness of formed film (µm) | 3 | 1 | 3 | 1 |
| Annealing time/Thickness of formed film | 3.3 | 10.0 | 3.3 | 10.0 |
| Applied voltage (V) | 50 | 50 | 50 | 50 |
| Volume resistivity (Ωcm) | 5.41E+07 | 3.47E+07 | 1.35E+12 | 1.80E+12 |

From TABLE 1, it was appreciated that that when no heating treatment was performed for the α-alumina powder, the volume resistivity was greatly lowered, and the insulating property was lowered. The reason for this phenomena is considered that a component included in the insulating film is gasified to cause the defect of the insulating film. On the other hand, it was appreciated that when the heating treatment was performed for the α-alumina powder, the volume resisitivity was great, and the insulating property was maintained.

From the above, it can be appreciated that by previously performing the heating treatment for the material particles before the film formation, it is possible to prevent the component contained in the insulating film from gasifying at the time of annealing treatment and causing any defect and destruction occur in the insulating film, thereby securing the insulating property.

Examples for investigating the effect on the film by the heating temperature for the material particles
<Example 2-1>
Fine powder of α-alumina, subjected to pulverizing treatment in the same manner as in Example 1-1 was placed in a muffle furnace (FP100, manufactured by Yamato Scientific Co., Ltd.), and the temperature in the furnace was raised up to 150°C by taking 90 minutes. After maintaining the temperature at 150°C for 300 minutes, the inside of the furnace was cooled by natural cooling, and the fine powder was taken out of the furnace. Then, the treated fine powder was used as material particles to form an insulating film in a similar manner as in Example 1-1 except for the following point, and a measurement was performed. Example 2-1 differs from Example 1-1 in that, in the annealing treatment, the temperature of the muffle furnace was raised up to 850°C, then the substrate having the film formed thereon was placed in the furnace, and maintained the temperature at 850°C for 30 minutes.

<Example 2-2>
Fine powder of α-alumina, subjected to pulverizing treatment in the same manner as in Example 1-1 was placed in a muffle furnace (FP100, manufactured by Yamato Scientific Co., Ltd.), and the temperature in the furnace was raised up to 450°C by taking 120 minutes. After maintaining the temperature at 450°C for 60 minutes, the inside of the furnace was cooled by natural cooling, and the fine powder was taken out of the furnace. Then, the treated fine powder was used as material particles to form an insulating film in a similar manner as in Example 1-1 except for the following point, and a measurement was performed. Example 2-2 differs from Example 1-1 in that, in the annealing treatment, the temperature of the muffle furnace was raised up to 850°C, then the substrate having the film formed thereon was placed in the furnace, and maintained the temperature at 850°C for 30 minutes.

<Example 2-3>
Fine powder of α-alumina, subjected to pulverizing treatment in the same manner as in Example 1-1 was placed in a muffle furnace (FP100, manufactured by Yamato Scientific Co., Ltd.), and the temperature in the furnace was raised up to 600°C by taking 120 minutes. After maintaining the temperature at 600°C for 60 minutes, the inside of the furnace was cooled by natural cooling, and the fine powder was taken out of the furnace. Then, the treated fine powder was used as material particles to form an insulating film in the same manner as in Example 2-2, and a measurement was performed.

<Example 2-4>
Fine powder of α-alumina, subjected to pulverization treatment in the same manner as in Example 1-1 was placed in a muffle furnace (FP100, manufactured by Yamato Scientific Co., Ltd.), and the temperature in the furnace was raised up to 850°C by taking 120 minutes. After maintaining the temperature at 850°C for 60 minutes, the inside of the furnace was cooled by natural cooling, and the fine powder was taken out of the furnace. Then, the treated fine powder was used as material particles to form an insulating film in a similar manner as in Example 2-2 except for the following point, and a measurement was performed. Example 2-4 differs from Example 2-2 in that the thickness of formed film was 2 µm.

<Measurement Results>
TABLE 2 shows results of measurement for Examples 2-1 to 2-4.

**TABLE 2**

| | EX. 2-1 | EX. 2-2 | EX. 2-3 | EX. 2-4 |
|---|---|---|---|---|
| Temperature raising time (min) | 90 | 120 | 120 | 120 |
| Heating temperature (°C) | 150 | 450 | 600 | 850 |
| Temperature maintaining time (min) | 300 | 60 | 60 | 60 |
| Cooling method | Natural cooling | Natural cooling | Natural cooling | Natural cooling |
| Substrate | SUS430 | SUS430 | SUS430 | SUS430 |
| Thickness of formed film (µm) | 3 | 3 | 3 | 2 |
| Annealing time/Thickness of formed film | 10.0 | 10.0 | 10.0 | 15.0 |
| Applied voltage (V) | 50 | 50 | 50 | 50 |
| Volume resistivity (Ωcm) | 7.43E+07 | 2.88E+09 | 3.05E+10 | 2.88E+09 |

From TABLE 2, it was appreciated that in a case in which the heating temperature for the α-alumina powder was 150°C (Example 2-1), the volume resistivity was greatly lowered, and the insulating property was lowered. The reason for this phenomena is considered that at this temperature, only the physisorbed water adhered to the surface of α-alumina powder was removed, and any additive(s) and/or crystal water are not removed, and that the remaining component or components are gasified at the time of the annealing treatment, thereby causing defect in the insulating film.

It was also appreciated that in a case in which the heating temperature for the α-alumina powder was 450°C (Example 2-2), the volume resistivity was somewhat great (great to some extent), and the insulating property was maintained to some extent. The reason for this phenomena is considered that at this temperature, in addition that the physisorbed water was removed, and that the additive(s) such as a dispersant and/or a sintering-aiding agent contained in the α-alumina powder are also removed, thereby making the extent of defect occurring at the time of the annealing treatment to be small. Further, it was appreciated that in a case in which the heating temperature for the α-alumina powder was 600°C (Example 2-3), the volume resistivity was further greater, and the insulating property was maintained satisfactorily. The reason for this phenomena is considered that at this temperature, the chemisorbed water such as crystal water contained in the α-alumina powder was removed as well, thereby hardly causing defect in the film at the time of the annealing treatment.

Furthermore, it was appreciated that in a case in which the heating temperature for the α-alumina powder was further raised up to 850°C (Example 2-4), the volume resistivity was great but was rather lower as compared with the case in which heating temperature was 600°C. The reason for this phenomena is considered as follows. Namely, when the heating was performed at around 850°C, the water existed between the particles is completely absent (removed), thereby causing the particles adhering to one another such that the particle size becomes large. When the aerosol containing the large particles are jetted onto the substrate, the following problems arise in some cases such that particles having been already jetted onto and deposited onto the substrate are damaged by particles subsequently jetted and deposited onto the substrate because the particles have a large weight; and that the particles which have been aggregated are separated upon colliding onto the substrate, consuming a part of the collision energy, thereby lowering the adhesive property of the particles to the substrate. Accordingly, the insulating property of the film is degraded.

As described above, it was appreciated that by removing not only the water adhered to the surfaces of particles, but also removing the additive or additives such as dispersant and/or sintering-aiding agent and the chemisorbed water such as crystal water, the occurrence of defect can be suppressed and a film having excellent characteristics can be obtained.

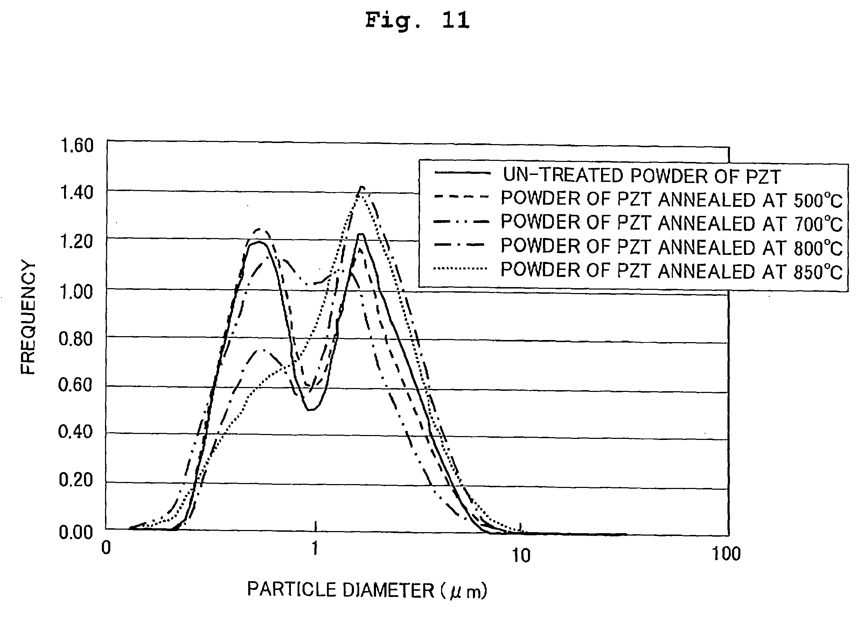

Examples and Comparative Examples for investigating the effect on the piezoelectric film by the presence or absence of heating treatment to the piezoelectric material particles
<Example 3-1>
1. Formation of Piezoelectric Film
   (1) Preparation of piezoelectric material particles
      As the material, PZT (obtained from Sakai Chemical Industry Co., Ltd.) was pulverized with a ball mill to obtain fine powder of PZT having a mean particle diameter of about 1 µm and a particle size distribution as shown in Fig. 11. The particle size distribution was measured by using a dry type particle-size distribution measuring apparatus (HELOS & RODOS, manufactured by Japan Laser Corporation). This fine powder was placed in a muffle furnace (FP100, manufactured by Yamato Scientific Co., Ltd.), and the temperature in the furnace was raised up to 800°C at a rate of 400°C/1h. After maintaining the temperature at 800°C for 3 hours, the inside of the furnace was cooled by natural cooling, and the fine powder was taken out of the furnace. Fig. 11 shows a particle size distribution of the fine powder after the heating treatment was performed therefor at 800°C as well as particles size distributions of the fine powder after the heating treatment was performed therefor at temperatures other than 800°C, respectively.
   (2) Formation of Film
      Stainless steel (SUS430) was used as the substrate, and an insulating layer of alumina was formed on the substrate by the AD method. Further, a Ti-Pt lower electrode layer was formed on the insulating layer with the sputtering method. Furthermore, on the lower electrode layer, a piezoelectric film was formed with the AD method by using the PZT powder prepared in above (1). Aerosol was jetted onto the substrate with the following condition for film formation of PZT piezoelectric film by the AD method that nozzle opening was 0.4 mm x 10 mm, pressure in the film forming chamber was 300 Pa, pressure in the aerosol chamber was 40,000 Pa, the kind of carrier gas was He, gas flow rate was 4.0 litter/min, the distance between nozzle and substrate was 10 to 30 mm. Thus, a piezoelectric film was formed. The thickness of the film, after the measurement of step (unevenness) by using a surface roughness tester was approximately 8 µm.
   (3) Annealing Treatment
      Next, annealing treatment was performed for the PZT piezoelectric film. The temperature in the muffle furnace was raised up to 850°C at a heating rate of 400°C/1h, then the substrate having the piezoelectric film formed thereon was placed in the furnace, and maintained the temperature at 850°C for 30 minutes. Afterwards, the inside of the furnace was cooled by natural cooling.
2. Measurement
Next, 10 pieces of substrates each having the PZT piezoelectric film formed thereon as described above were prepared, and dielectric constant and dielectric loss were measured for the 10 pieces of substrate by using an impedance analyzer (HP-4194A, manufactured by Hewlett-Packard Development Company, L.P.).

<Comparative Example 3-1>
PZT piezoelectric film was formed in a similar manner as that in Example 3-1 except that no heating treatment was performed for the PZT powder in the preparation of the particles of PZT piezoelectric material, and the measurement was performed.

<Measurement Results>
TABLE 3 shows mean values of dielectric constant and dielectric loss measured in Examples 3-1 and Comparative
Example 3-1, respectively.

**TABLE 3**

| Example 3-1 | | Comparative Example 3-1 | |
|---|---|---|---|
| Dielectric constant | Dielectric loss | Dielectric constant | Dielectric loss |
| 1565 | 11 | 1362 | 13 |

From TABLE 3, it is appreciate that when the PZT powder was subjected to the heating treatment (Example 3-1), the mean value of dielectric constant is greater and the mean value of dielectric loss is smaller than those in a case in which the PZT powder was not subjected to the heating treatment (Comparative Example 3-1).

Accordingly, it is appreciated that satisfactory ferroelectric property can be obtained in a case in which the PZT powder is subjected to the heating treatment than in a case in which the PZT powder is not subjected to the heating treatment.

Examples for investigating the effect on the piezoelectric film by the heating temperature for the particles of the piezoelectric material
<Example 4-1>
1. Formation of piezoelectric film
   (1) Preparation of piezoelectric material particles As the material, PZT (obtained from Sakai Chemical Industry Co., Ltd.) was pulverized with a ball mill to obtain fine powder of PZT having a mean particle diameter of about 1 µm and a particle size distribution as shown in Fig. 11. This fine powder was placed in a muffle furnace (FP100, manufactured by Yamato Scientific Co., Ltd.), and the temperature in the furnace was raised up to 500°C at a rate of 400°C/1h. After maintaining the temperature at 500°C for 3 hours, the inside of the furnace was cooled by natural cooling, and the fine powder was taken out of the furnace. Fig. 11 shows a particle size distribution of the fine powder after the heating treatment was performed at 500°C as well as particles size distributions of the fine powder after the heating treatment was performed at temperatures other than 500°C, respectively. The particle size distributions were respectively measured by using a dry type particle-size distribution measuring apparatus (HELOS & RODOS, manufactured by Japan Laser Corporation).
   (2) Film formation
      A glass plate was used as the substrate, and the PZT powder prepared in above (1) was used as the material particles. Aerosol was jetted onto the substrate with the following condition for film formation of the piezoelectric film by the AD method that nozzle opening was 0.4 mm x 10 mm, pressure in the film forming chamber was 300 Pa, pressure in the aerosol chamber was 40,000 Pa, the kind of carrier gas was He, gas flow rate was 4.0 litter/min, the distance between nozzle and substrate was 10 to 30 mm. Thus, a piezoelectric film was formed. The thickness of the film, after the measurement of step (unevenness) by using a surface roughness tester was approximately 2 to 3 µm.
   (3) Annealing treatment
      Next, annealing treatment was performed for the PZT piezoelectric film. The temperature in the muffle furnace was raised up to 850°C at a heating rate of 400°C/1h, then the substrate having the piezoelectric film formed thereon was placed in the furnace, and maintained the temperature at 850°C for 30 minutes. Afterwards, the inside of the furnace was cooled by natural cooling.
2. Observation of cross section of piezoelectric film
   The substrate, having the PZT piezoelectric film was formed thereon in such a manner, was cut in a direction of thickness of the substrate, and the cross section was photographed and observed with FE-SEM (Field Emission-Scanning Electron Microscope).

<Examples 4-2>
A PZT piezoelectric film was formed in a similar manner as that in Example 4-1 except that the temperature in the muffle furnace was raised up to 700°C in the preparation of the particles of PZT piezoelectric material and that the temperature in the furnace was maintained at 700°C for 3 hours. Then, the cross section of the piezoelectric film was observed.

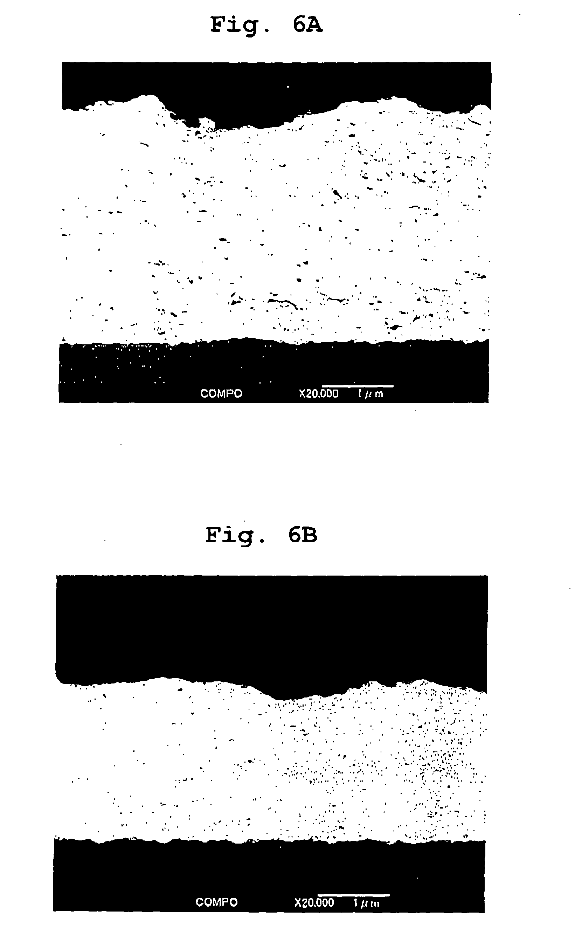

<Observation Results>
States of piezoelectric films in Examples 4-1 and 4-2 are shown in Figs. 6A and 6B, respectively. Each of the drawings shows a state in which the PZT piezoelectric film is formed on a glass plate.

From Figs. 6A and 6B, it is appreciated in a case in which the heating treatment was performed at 700°C (Example 4-2), voids are formed to an extent smaller than in a case in which the heating treatment was performed at 500°C (Example 4-1).

The reason for this phenomena is considered that the powder resin was not evaporated in a case in which the heating treatment was performed at 500°C, but the powder resin was evaporated in the case in which the heating treatment was performed at 700°C. The voids, occurring in a case of heating treatment at 700°C, are considered to be due to the chemisorbed water.

Examples and Comparative Example for investigating the relationship between the heating treatment to piezoelectric material particles and the crystallization
<Example 5-1>
1. Preparation of piezoelectric material particles
   As the material, PZT (obtained from Sakai Chemical Industry Co., Ltd.) was pulverized with a ball mill to obtain fine powder of PZT having a mean particle diameter of about 1 µm and a particle size distribution as shown in Fig. 11. This fine powder was placed in a muffle furnace (FP100, manufactured by Yamato Scientific Co., Ltd.), and the temperature in the furnace was raised up to 600°C at a rate of 400°C/1h. After maintaining the temperature at 600°C for 3 hours, the inside of the furnace was cooled by natural cooling, and the fine powder was taken out of the furnace.
2. X-ray diffraction measurement
   With respect to the PZT fine powder subjected to the heating treatment in above Item 1, X-ray diffraction measurement was performed with a vertical type goniometer (RINT-2000, manufactured by Rigaku Corporation). The condition for measurement by using the goniometer RINTO 2000 was as follows: Attachment was multi-purpose (for thin and standard films) specimen support; Monochromator was a fixed monochromator; Scanning Mode was 2 Theta/Theta; Scanning Type was continuous scanning; Excitation source for x-Ray was Cu, 40kV/40mA; Divergent slit was 1° ; Divergent regulation vertical slit: 10 mm; Scatter slit was 1° ; Receiving slit was 0.15 mm; and Monochromatic receiving slit was 0.6 mm.

<Example 5-2>
Particles of the PZT piezoelectric material were prepared in a similar manner as in Example 5-1 except that the temperature of the muffle furnace was raised up to 800°C and was maintained at 800°C for 3 hours in the preparation of the PZT piezoelectric material particles, and the X-ray diffraction measurement was performed.

<Comparative Example 5-1>
Particles of the PZT piezoelectric material were prepared in a similar manner as that in Example 5-1 except that no heating treatment was performed for the PZT powder in the preparation of the particles of PZT piezoelectric material, and the X-ray diffraction measurement was performed.

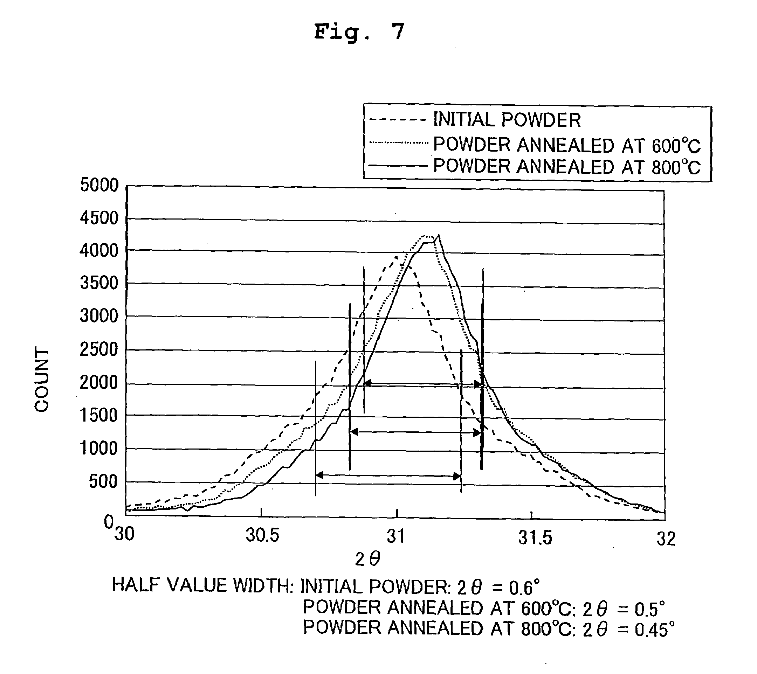

<Measurement Results>
A graph in Fig. 7 shows a change in measured value of X-ray diffraction in each of Examples 5-1, 5-2 and Comparative Example 5-1.

In the graph shown in Fig. 7, a half value width (width of waveform having a peak) was 0.5° in Example 5-1, 0.45° in Example 5-2, and 0.6° in Comparative Example 5-1. Further, the peak become higher in order of Comparative Example 5-1, Example 5-1 and Example 5-2.

In general, it can be approved that as the peak increases and the half value width becomes smaller, the crystallization is advanced further. Accordingly, it can be approved that the crystallization is advanced further in a case in which the heating treatment was performed (Examples 5-1, 5-2) than in a case in which no heating treatment was performed (Comparative Example 5-1); and that, when comparing the heating treatments at 600°C and 800°C, the crystallization is advanced further in a case in which the heating treatment was performed at 800°C (Example 5-2) than in a case in which the heating treatment was performed at 600°C (Example 5-1). In other words, since a content of the crystal water is smaller in the case with the heating treatment than that in the case of no heating treatment, an amount of gas generation can be suppressed to be smaller even when the annealing treatment is performed at a high temperature, thereby preventing the destruction of the film.

Example for investigating the heating treatment to piezoelectric material particles and the change in thermogravimetry
<Example 6>
With respect to 165.750 mg of the PZT powder, thermogravimetry (TG) was measured and differential thermal analysis (DTA) was performed by using a thermobalance apparatus (TG-8120, manufactured by Rigaku Corporation) at conditions that the atmosphere was air 200ml/min, the temperature was raised from room temperature of 25°C up to 900°C at a rate of 10°C/min, and sampling time was ls.

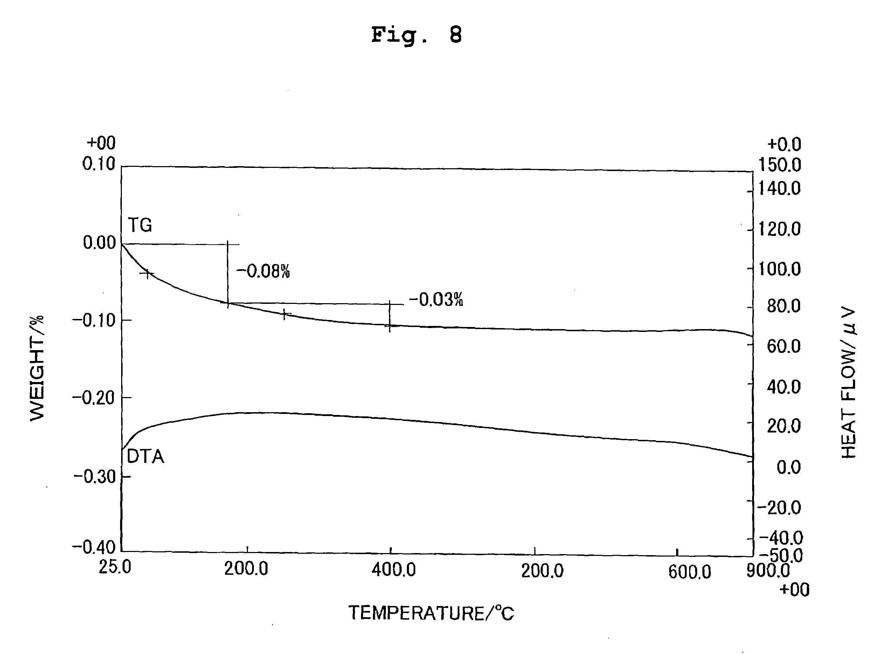

<Measurement Results>
Measurement results of the thermogravimetry and differential thermal was shown in a graph of Fig. 8.

From the graph shown in Fig. 8, it is appreciated that in the thermogravimetry weight loss rate at 180°C was 0.08 %, which is not more than 0.15 %; and that weight loss rate at 600°C was 0.113 %, which is not more than 0.18 %; and weight loss rate at 900°C was 0.116 %, which is not more than 0.2 %.

Examples for investigating relationship between the heating treatment to piezoelectric material particles and the electrical characteristics
<Example 7-1>
1. Formation of piezoelectric film
   (1) Preparation of piezoelectric material particles
      As the material, PZT (obtained from Sakai Chemical Industry Co., Ltd.) was pulverized with a ball mill to obtain fine powder of PZT having a mean particle diameter of about 1 µm and a particle size distribution as shown in Fig. 11. The particle size distribution was measured by using a dry type particle-size distribution measuring apparatus (HELOS & RODOS, manufactured by Japan Laser Corporation). This fine powder was placed in a muffle furnace (FP100, manufactured by Yamato Scientific Co., Ltd.), and the temperature in the furnace was raised up to 600°C at a rate of 400°C/1h. After maintaining the temperature at 600°C for 3 hours, the inside of the furnace was cooled by natural cooling, and the fine powder was taken out of the furnace.
   (2) Film formation
      An alumina substrate was used as the substrate, and the PZT powder prepared in above (1) was used to form a piezoelectric film on the substrate with the AD method, and a Ti/Pi electrode layer was formed on the piezoelectric film with the sputtering method. Aerosol was jetted with the following condition for the formation of PZT piezoelectric film by the AD method that: nozzle opening was 0.4 mm x 10 mm, pressure in the film forming chamber was 300 Pa, pressure in the aerosol chamber was 40,000 Pa, the kind of carrier gas was He, gas flow rate was 4.0 litter/min, the distance between nozzle and substrate was 10 to 30 mm. Thus, the piezoelectric film was formed. The thickness of the film, after the measurement of step (unevenness) by using a surface roughness tester was approximately 8 µm.
   (3) Annealing treatment
      Next, annealing treatment was performed for the PZT piezoelectric film. The temperature in the muffle furnace was raised up to 850°C at a heating rate of 400°C/1h, then the substrate having the piezoelectric film formed thereon was placed in the furnace, and maintained the temperature at 850°C for 30 minutes. Afterwards, the inside of the furnace was cooled by natural cooling and the substrate was taken out of the furnace.
2. Measurement
   With respect to the substrate having the PZT piezoelectric film and the Ti/Pt electrode formed thereon as described above, an upper electrode having a size of 125 µm and 200 µm was formed with an AU coater, and dielectric constant and electro capacitance were measured with an impedance analyzer (HP-4194A, manufactured by Hewlett-Packard Development Company, L.P.).

<Example 7-2>
The PZT fine powder subjected to the pulverizing treatment in the same manner as in Example 7-1 was placed in a muffled furnace, and the temperature inside of the furnace was raised up to 700°C at a heating rate of 400°C/1h. After maintaining the temperature at 700°C for 3 hours, the inside of the furnace was cooled by natural cooling, and the fine powder was taken out of the furnace. The treated fine powder was used to form a PZT piezoelectric film on an alumina substrate, a Ti/Pt electrode was formed on the piezoelectric film, and then, after performing the annealing treatment in the same manner as in Example 7-1, the measurement was performed.

<Example 7-3>
The PZT fine powder subjected to the pulverizing treatment in the same manner as in Example 7-1 was placed in a muffled furnace, and the temperature inside of the furnace was raised up to 800°C at a heating rate of 400°C/1h. After maintaining the temperature at 800°C for 3 hours, the inside of the furnace was cooled by natural cooling, and the fine powder was taken out of the furnace. The treated fine powder was used to form a PZT piezoelectric film on an alumina substrate, a Ti/Pt electrode was formed on the piezoelectric film, and then, after performing the annealing treatment in the same manner as in Example 7-1, the measurement was performed.

<Example 7-4>
The PZT fine powder, subjected to the pulverizing treatment in the same manner as in Example 7-1, was placed in a muffled furnace, and the temperature inside of the furnace was raised up to 900°C at a heating rate of 400°C/1h. After maintaining the temperature at 900°C for 3 hours, the inside of the furnace was cooled by natural cooling, and the fine powder was taken out of the furnace. The treated fine powder was used to form a PZT piezoelectric film on an alumina substrate, a Ti/Pt electrode was formed on the piezoelectric film, and then, after performing the annealing treatment in the same manner as in Example 7-1, the measurement was performed.

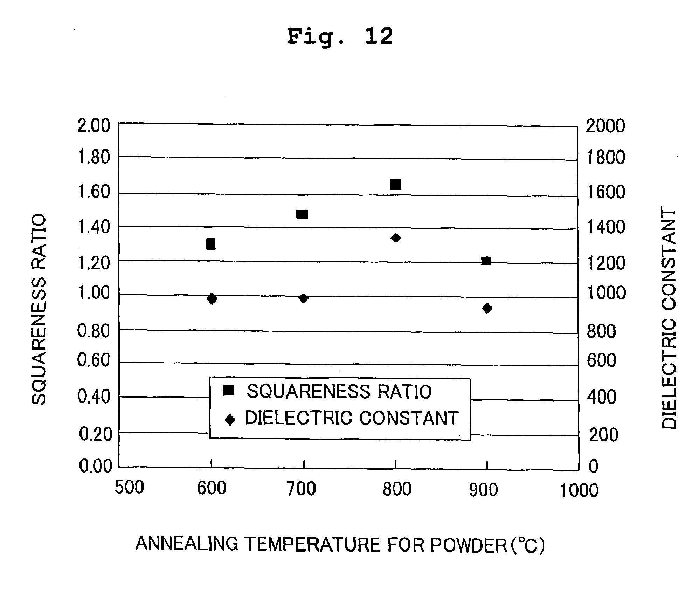

<Measurement Results>
With respect to each of Examples 7-1 to 7-4, Fig. 12 shows a squareness ratio which is capacitance relative to the voltage, together with dielectric constant.

From Fig. 12, it is appreciated that as the temperature of heating treatment for the piezoelectric material particles is raised, the squareness ratio, which is a ratio of applied voltage to remanent polarization when a polarization direction is changed, becomes greater; and that the ferroelectric property is increased. This phenomena reaches its maximum value at around 800°C. When the temperature is raised more than 800°C, the particles exceed a range appropriate for the film formation and the density of the film is lowered, which in turn degrades the squareness ratio, thereby lowering the ferroelectric property.

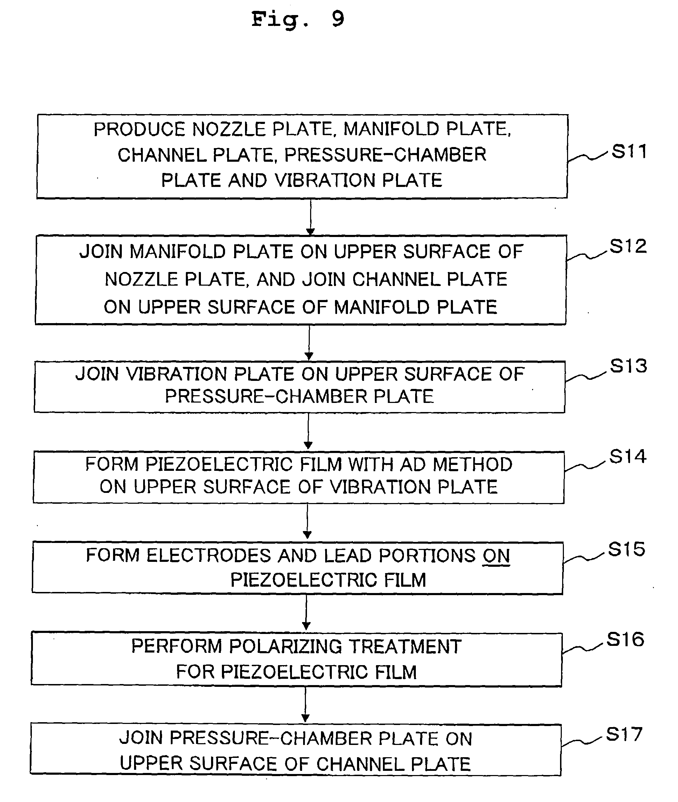

Method of producing ink-jet head
A method of producing an ink-jet head, which uses the piezoelectric film of the present invention as described, will be briefly explained with reference to Figs. 1, 2 and 9.

First, a nozzle plate 12, a manifold plate 13, a channel plate 14, a pressure-chamber plate 15 and a vibration plate 2 each of which has the construction as
described using Fig. 1 are produced (Step S11).

Next, as shown in Fig. 1, the manifold plate 13 is joined to the upper surface of the nozzle plate 12, and the channel plate 14 is joined to the upper surface of the manifold plate 13 (Step S12). These plates are joined to one another with an epoxy-based thermosetting adhesive.

Subsequently, as shown in Fig. 2, the vibration plate 2 is joined to the upper surface of the pressure-chamber plate 15 (Step S13). Afterwards, by using the apparatus explained in relation to Fig. 3, the piezoelectric film 3 of the present invention is formed with the aerosol deposition method (AD method) on the upper surface of the vibration plate 2 (Step S14).

Next, on the upper surface of the formed piezoelectric film 3, electrodes 4 and lead portions are formed with the photolithography etching method, the screen printing method or the like (Step S15). Afterwards, a strong electric field is applied between the upper electrodes 4 and the vibration plate 2, thereby polarizing the piezoelectric film 3 (Step S16).

Finally, the pressure-chamber plate 15 is joined to the upper surface of the channel plate 14 (Step S17). With this, an ink-jet head 10, provided with the ink-channel forming body 11 and the actuator plate 1 as shown in Fig. 1, is completed.

The scope of the present invention is not intended to be limited by the embodiment and examples as described above, and the following construction is included in the scope of the present invention, and the scope of the present invention also encompasses equivalents thereof.

In the embodiment as described above, an explanation was made about a case the piezoelectric film 3 is formed directly on the vibration plate 2, but the present invention is applicable in the same manner also to a case in which an intermediate layer such as a lower electrode or the like is separately arranged on the vibration plate, and the piezoelectric film is formed on the intermediate layer.

In the embodiment as described above, an explanation was made about a case in which the present invention is applied to the formation of the piezoelectric film 3 in the actuator plate 1. However, the producing method of the present invention is applicable in the same manner also to a case in which, for example, an insulating layer having a various kind of functions such as a diffusion-preventing layer and the like is formed of ceramics between the piezoelectric film and the vibration plate.

## Claims

1. A method of producing a film, comprising:
a heating treatment step for performing a heating treatment for ceramic particles;
a film-forming step for forming the film by jetting, onto a substrate, an aerosol containing the ceramic particles which have been subjected to the heating treatment so as to adhere the ceramic particles to the substrate; and
an annealing-treatment step for performing an annealing treatment for the film.

2. The method according to claim 1, wherein a heating temperature in the heating treatment step is not less than a temperature at which chemisorbed water contained in the ceramic particles is released.

3. The method according to claim 1, wherein a heating temperature in the heating treatment step is not less than an annealing temperature in the annealing treatment step.

4. The method according to claim 1, wherein a heating temperature in the heating treatment step is 450°C to 850°C.

5. The method according to claim 1, wherein a heating time in the heating treatment is not less than 30 minutes.

6. The method according to claim 1, further comprising a dry pulverization step after the heating treatment step.

7. The method according to claim 1, wherein the ceramic particles are particles of a piezoelectric material.

8. The method according to claim 1, wherein the ceramic particles are obtained by:
a mixed powder producing step for producing a mixed powder by mixing a plurality of kinds of powders;
a sintered body producing step for producing a sintered body by calcinating the mixed powder; and
a powder producing step for producing powder of the ceramics material by pulverizing the sintered body.

9. The method according to claim 1, wherein the ceramic particles are particles of α-alumina.

10. The method according to claim 1, wherein the ceramic particles are particles of lead zirconate titanate.

11. A method of producing an ink-jet head which includes an ink channel forming body provided with a plurality of pressure chambers each of which communicates with an ink discharge nozzle for discharging an ink and each of which has an opening, the opening being open on a side of a surface of the ink channel forming body; and a piezoelectric actuator provided with a vibration plate arranged on the side of the surface of the ink channel forming body so as to close the opening of each of the pressure chambers, and a piezoelectric film stacked on the vibration plate, the method comprising:
a heating treatment step for performing a heating treatment for particles of a piezoelectric material;
a piezoelectric film-forming step for forming the piezoelectric film by jetting, onto the vibration plate, an aerosol containing the particles of the piezoelectric material which have been subjected to the heating treatment so as to adhere the particles of the piezoelectric material to the vibration plate;
an annealing-treatment step for performing an annealing treatment for the piezoelectric film; and
an electrode layer forming step for forming an electrode layer on the piezoelectric film.

12. The method according to claim 11, wherein a heating temperature in the heating treatment step is not less than a temperature at which chemisorbed water contained in the particles of the piezoelectric material is released.

13. The method according to claim 11, wherein a heating temperature in the heating treatment step is not less than an annealing temperature in the annealing treatment step.

14. The method according to claim 11, wherein a heating temperature in the heating treatment step is 450°C to 850°C.

15. The method according to claim 11, wherein a heating time in the heating treatment is not less than 30 minutes.

16. The method according to claim 11, further comprising a dry pulverization step after the heating treatment step.

17. The method according to claim 11, wherein the particles of the piezoelectric material are obtained by:
a mixed powder producing step for producing a mixed powder by mixing a plurality of kinds of powders;
a sintered body producing step for producing a sintered body by calcinating the mixed powder; and
a powder producing step for producing powder of the piezoelectric material by pulverizing the sintered body.

18. The method according to claim 11, wherein the particles of the piezoelectric material are particles of lead zirconate titanate.
